# EUROPEAN PATENT SPECIFICATION

(11) **EP 4 631 908 B1**
(45) Date of publication and mention of the grant of the patent: **28.10.2026**
(21) Application number: 24169119.5
(22) Date of filing: 09.04.2024
(51) Int. Cl.: B81B 3/00

(54) **ELECTROSTATIC ACTUATOR**
ELEKTROSTATISCHER BETÄTIGER
ACTIONNEUR ÉLECTROSTATIQUE

(43) Date of publication of application: 15.10.2025
(73) Proprietor: Murata Manufacturing Co., Ltd., Nagaokakyo-shi, Kyoto 617-8555 (JP)
(72) Inventor: LIUKKU, Matti, 00320 Helsinki (FI)
(74) Representative: Boco IP Oy Ab

(56) References cited:
- US-A1- 2009 267 445
- US-A1- 2014 126 031

## Description

### FIELD OF THE DISCLOSURE

The present disclosure relates to an electrostatic actuator.

### BACKGROUND OF THE DISCLOSURE

Microelectromechanical (MEMS) electrostatic actuators can be used to generate force in the z-direction. Vertical electrostatic actuators, as described in, for example, WO03035542, comprise comb structure, where one portion of the comb structure is relatively fixed and the other is moving. The strain is induced in fixed portion to partially deform it into cavity followed by applying a voltage between portions, the moving portion moves towards the deformed fixed portion. Such electrostatic actuators require large actuation voltage applied in order to move the moving structure. Therefore, a solution which may reduce the required actuation voltage was needed.

US20140126031A1 and US20090267445A1 disclose comb drive structures with tapered combs which have the effect of reducing the activation voltage, however, the fabrication process is complex.

### BRIEF DESCRIPTION OF THE DISCLOSURE

An object of the present disclosure is to provide an electrostatic actuator so as to solve the above problem regarding complex fabrication.

The invention is defined in the independent claims. Some embodiments of the disclosure are disclosed in the dependent claims.

The disclosure is based on the idea of two sets of comb fingers, aligned one above the other in a vertical direction, wherein the comb fingers of at least one set are tapered in the vertical direction.

An advantage of the electrostatic actuator of the disclosure is that the electrostatic force between comb fingers is increased and, therefore, lower actuation voltage is required.

### BRIEF DESCRIPTION OF THE DRAWINGS

In the following the disclosure will be described in greater detail by means of preferred embodiments with reference to the accompanying drawings, in which:
Figure 1a illustrates an xy-plane view of a microelectromechanical electrostatic actuator with a first set and a second set of comb fingers;
Figure 1b illustrates an xz-plane view of a non-actuated state of the electrostatic actuator;
Figure 1c illustrates an xz-plane view of an actuated state of the electrostatic actuator;
Figure 2a illustrates a example of the electrostatic actuator with a movable element;
Figure 2b illustrates a cross-section of the electrostatic actuator with a movable element in a) non-actuated state and in b) actuated state;
Figure 3a illustrates an example of the electrostatic actuator with four first sets and four second sets of comb fingers, which form four actuator elements, in actuated state;
Figure 3b illustrates a cross-section of the electrostatic actuator with four actuator elements in a) non-actuated state and in b) actuated state;
Figure 4 illustrates an example of the electrostatic actuator which comprises eight actuator elements and a reflector;
Figure 5 illustrates a method of fabrication of the electrostatic actuator.

The figures are for illustrative purposes only and are not shown in scale.

### DETAILED DESCRIPTION OF THE DISCLOSURE

The disclosure relates to a microelectromechanical (MEMS) electrostatic actuator. Thereafter, the microelectromechanical electrostatic actuator is referred to as an electrostatic actuator or a MEMS electrostatic actuator. The electrostatic actuator may also be referred to as a capacitive actuator.

A microelectromechanical electrostatic actuator comprising a double layer, wherein the double layer defines a horizontal plane and a vertical direction, wherein the vertical direction is perpendicular to the horizontal plane, and wherein the horizontal plane defines an x-direction, and wherein the double layer comprises an actuator region in the horizontal plane, and wherein the double layer comprises a first layer and a second layer, and the first and the second layers are one above the other in the vertical direction; a first set of comb fingers in the first layer and a second set of comb fingers in the second layer, wherein the first set of comb fingers and the second set of comb fingers are aligned in the actuator region; and wherein the x-direction width of the stator comb fingers is tapered along the vertical direction.

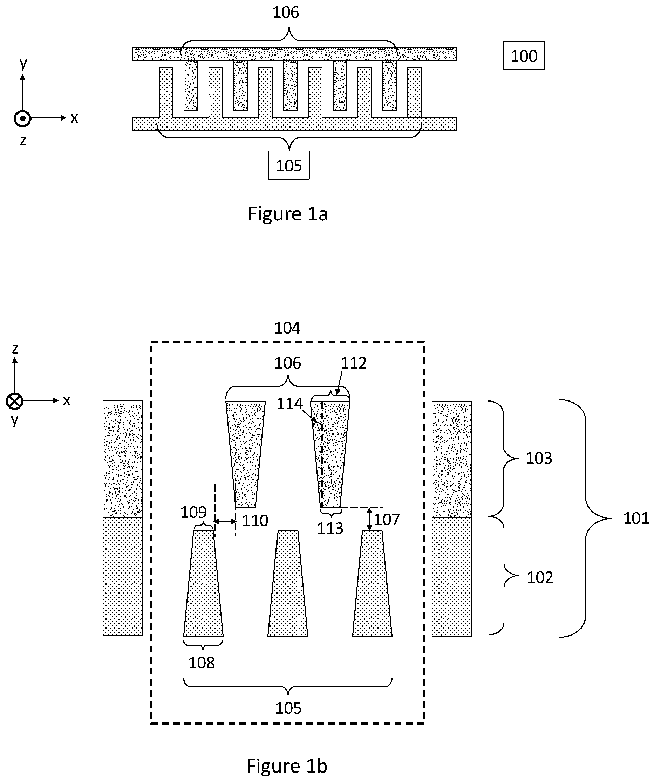

A MEMS electrostatic actuator 100 of this disclosure, illustrated in Figure 1a, comprises a double layer 101 with two superimposed layers. A x-z cross section of the electrostatic actuator is illustrated in Figure 1b. The term double layer signifies a structure which comprises two layers connected to each other from which the electrostatic actuator is formed. The double layer 101 defines a horizontal plane (xy-plane). Specifically, static structures in the double layer may be formed in the horizontal plane. The horizontal plane comprises a x-direction. The horizontal plane may also comprise a y-direction. The x-direction may be perpendicular to y-direction. A vertical direction is perpendicular to the horizontal plane. The vertical direction may be aligned with a z-axis. In this disclosure, the terms "horizontal" and "vertical" do not refer to the orientation of the device with regard to the direction of earth's gravitational field either when the device is manufactured or when it is in use. Instead, the word "horizontal" simply defines a plane and "vertical" defines a direction which is perpendicular to that plane.

The micromechanical electrostatic actuator, wherein material of the double layer may be silicon.

A second layer 103 may be on top of a first layer 102 in the vertical direction.

A top surface of the first layer 102 may be attached to a bottom surface of the second layer 103. The first layer 102 and the second layer 103 may be attached to each other with direct bonding. The material of the first layer and the second layer may be silicon. The first layer may be called a device layer. It may be formed from a wafer (which may be called a device wafer) or by a layer which has been deposited on a surface. Accordingly, the horizontal plane may correspond to the plane of the wafer and the vertical direction may be perpendicular to the plane of the wafer. Alternatively, the horizontal plane may be defined by the surface on which the layer is deposited. Alternatively, the second layer may be called a device layer. It may be formed from a wafer (which may be called a device wafer) or by a layer which has been deposited on a surface. Accordingly, the horizontal plane may correspond to the plane of the wafer and the vertical direction may be perpendicular to the plane of the wafer. Alternatively, the horizontal plane may be defined by the surface on which the layer is deposited.

The first layer may comprise the static structures of the electrostatic actuator. Alternatively, some structures in the first layer may be moving structures. The second layer may comprise the moving structures of the electrostatic actuator. Alternatively, some structures in the second layer may be static structures.

The double layer comprises an actuator region 104 in the horizontal plane. The actuator region 104 may extend in the vertical direction from the first layer 102 to the second layer 103. In other words, the part of the actuator region 104 in the second layer 103 may be above the part of the actuator region 104 in the first layer 102.

### Electrostatic comb structure

The electrostatic actuator comprises a first set of comb fingers 105 in the first layer 102 and a second set of comb fingers 106 in the second layer 103, as illustrated in Figures 1a - 1c. The first set of comb fingers 105 and the second set of comb fingers 106 are aligned in the actuator region 104. In other words, the second set of comb fingers 106 may be above the first set of comb fingers 105 in the vertical direction. The comb fingers of the first set 105 may be alternated with the comb fingers of the second set 106 in the x-direction. The second set of comb fingers 106 may be mechanically connected to a movable element. (not illustrated in Figures 1a - 1c). The movable element may be suspended from the static structures with flexible suspenders, which allows the second set of comb fingers 106 move with respect to the first set of comb fingers 105.

Since the first layer may comprise the static structures of the electrostatic actuator, the first set of comb fingers 105 may be fixed. In particular, the first set of comb fingers 105 may be immobile in relation to the surrounding static structures of the actuator. Since the second layer may comprise the moving structures of the electrostatic actuator, the second set of comb fingers 106 may be moving in relation to the first set of comb fingers 105 when the voltage is applied between them.

A distance between the first set of comb fingers and the second set of comb fingers in the vertical direction (a vertical gap 107), illustrated in Figure 1b, may allow large displacement of the second set of comb fingers 106 towards the first set of comb fingers 105. The vertical gap 107 needs to be small enough to allow presence of fringe fields between the comb fingers of the first and the second sets 105-106 before overlapping. The gap may be recessed using, for example, LOCal Oxidation of Silicon (LOCOS) process prior to fabrication of the comb fingers of the first and the second sets.

The micromechanical electrostatic actuator, wherein the x-direction width of the comb fingers of the second set may be tapered along the vertical direction.

The micromechanical electrostatic actuator, wherein the x-direction width of the comb fingers of the first set and the second set may be tapered from 4.5 um to 3 um.

The x-direction width 108-109 of the comb fingers of the first set 105 is tapered along the vertical direction, as illustrated in Figure 1b. In other words, the shape of the first set of comb fingers 105 may be tapered in the positive vertical direction or in the negative vertical direction. In this disclosure, the term "tapered" refers to gradual diminution of width in an elongated object and/or becoming progressively smaller in width toward one end. In other words, the x-direction width 108-109 of the first set of comb fingers 105 may gradually become smaller along the vertical direction. Specifically, the x-direction width 108-109 of the first set of comb fingers may gradually become smaller when z-coordinate is increasing. Alternatively, the x-direction width 108-109 of the first set of comb fingers may gradually become smaller when z-coordinate is decreasing.

The x-direction width 112-113 of the comb fingers of the second set 106 may be tapered along the vertical direction, as illustrated in Figure 1b. In other words, the shape of the second set of comb fingers 106 may be tapered along the vertical direction. In other words, the x-direction width 112-113 of the second set of comb fingers 106 may gradually become smaller when z-coordinate is changing. Specifically, the x-direction width 112-113 of the second set of comb fingers may gradually become smaller when z-coordinate is decreasing. Alternatively, the x-direction width 112-113 of the second set of comb fingers may gradually become smaller when z-coordinate is increasing.

One specific example of how the comb fingers may be tapered is illustrated in Figure 1b. The comb fingers in the first set 105 may be tapered in the positive vertical direction, while the comb fingers in the second set 106 may be tapered in the negative vertical direction. Alternatively, the comb fingers in the first set 105 may be tapered in the negative vertical direction, while the comb fingers in the second set 106 may be tapered in the positive vertical direction (not illustrated).

In particular, the width in the x-direction of the individual comb finger may be 2-5 um. The width in the x-direction of the individual comb finger may be more than 2 um, more than 2.5 um, or more than 3.5 um. The width in the x-direction of the individual comb finger may be less than 5 um, less than 4 um, less than 3um, less than 2.5 um. Specifically, the tapered comb finger may have x-direction width of 4.5 um in its widest portion (such as, for example, 108 or 112) and 2.5 um in its narrowest portion (such as, for example, 109 and 113).

Each comb finger of the first and the second sets 105-106 may comprise a first end and a second end. The first and the second end may be opposite to each other. The first ends of the comb fingers of the first set may face the first ends of the comb fingers of the second set. The x-direction width of the first end of each finger (such as, for example, 108 or 113) may be smaller than the x-direction width of the second end of each finger (such as, for example, 108 or 112). Specifically, the x-direction width of the first end of each finger may be 2.5 um, and the x-direction width of the second end of each finger may be 4.5 um.

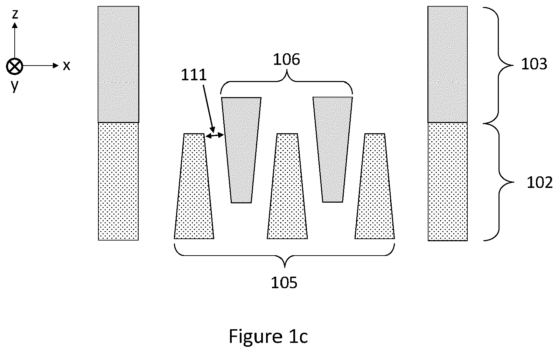

Figure 1b illustrates the electrostatic actuator in a non-actuated state. In an actuated state of the electrostatic actuator, the second set of comb fingers 106 may be configured to move as in Figure 1c. The second set of comb fingers 106 may move in the negative vertical direction so that the comb fingers of the second set 106 are pushed in-between the comb fingers of the first set 105. In other words, when the electrostatic actuator is in the actuated state, the comb fingers of the second set 106 may move towards the comb fingers of the first set 105 so that the comb fingers of the second set 106 are interdigitated with the comb fingers of the first set 105. Tapering of the comb fingers may allow the comb fingers of the second set to move deeper in between the comb fingers of the first set due to increased electrostatic force, thus allowing larger tilt angle than would be achievable with non-tapered comb fingers.

An x-direction distance 110 between the comb fingers of the first 105 and the second 106 sets may be 3 - 5 um in the non-actuated state as in Figure 1b. The x-direction distance 110 between the comb fingers of the first 105 and the second 106 sets may be more than 3 um, or more than 4 um in the non-actuated state. The x-direction distance 110 between the comb fingers of the first 105 and the second 106 sets may be less than 5 um, or less than 3.5 um in the non-actuated state. Specifically, the x-direction distance 110 between the comb fingers of the first and the second sets may be 3 um in the non-actuated state.

An x-direction distance 111 between the comb fingers of the first and the second sets may be 2 - 4 um in the actuated state as in Figure 1c. The x-direction distance 111 between the comb fingers of the first and the second sets may be more than 2 um, or more than 3 um in the actuated state. The x-direction distance 111 between the comb fingers of the first and the second sets may be less than 4 um, or less than 2.5 um in the actuated state. Specifically, the x-direction distance 111 between the comb fingers of the first and the second sets may be 2.25 um in the actuated state.

The micromechanical electrostatic actuator, wherein a tapering angle may be more than 0.1 degrees.

The micromechanical electrostatic actuator, wherein the height of the comb fingers of the first set and the second set in the vertical direction may be 50 um.

The height of the comb fingers of the first set and the second set in the vertical direction may be more than 50 um. The height of the comb fingers of the first set and the second set in the vertical direction may be 50 - 100 um. The height of the comb fingers of the first set and the second set in the vertical direction may be more than 50 um, more than 70 um. The height of the comb fingers of the first set and the second set in the vertical direction may be less than 100 um, less than 75 um. The tapering angle, such as 114 in Figure 1b, may be more than 0.1 deg. Specifically, the tapering angle may be 0.2 - 0.6 deg. The tapering angle may be more than 0.2 deg, more than 0.4 deg. The tapering angle may be less than 0.6 deg, less than 0.3 deg.

Tapering of the comb fingers as described below may increase electric force between the comb fingers of the first and the second set in the actuated state of the electrostatic actuator, thus lowering the maximum actuation voltage requirement. In addition, tapering may allow larger movement of the comb fingers of the second set.

The electrostatic actuator may be either a driving electrostatic actuator or a sensing electrostatic actuator, or both a driving electrostatic actuator and a sensing electrostatic actuator. In the driving electrostatic actuator, the second set of comb fingers may be configured to move towards the first set of comb fingers when electric field is applied between them. Thus, the driving electrostatic actuator may be configured to move the moving structures connected to the second set of comb fingers in response to the applied signal. Tapering of the comb fingers may increase electric force between them and allow lower actuation voltage than would be required with non-tapered comb fingers. The driving electrostatic actuator may also be called the capacitive comb drive.

On the opposite, the sensing electrostatic actuator may be configured to detect the position of the second set of comb fingers and the moving structures in relation to the first set of comb fingers. The sensing of the displacement may be based on change of the capacitance between the comb fingers of the first set and the second set. In other words, when the second set of comb fingers moves in relation to the first set of comb fingers, the capacitance change depends on the amount of displacement. The sensing electrostatic actuator may also be called the comb sense capacitor.

### Electrostatic actuator with a movable element

The micromechanical electrostatic actuator, wherein a movable element may be attached to the second set of comb fingers of the micromechanical electrostatic actuator.

The micromechanical electrostatic actuator, wherein the movable element may be in the double layer.

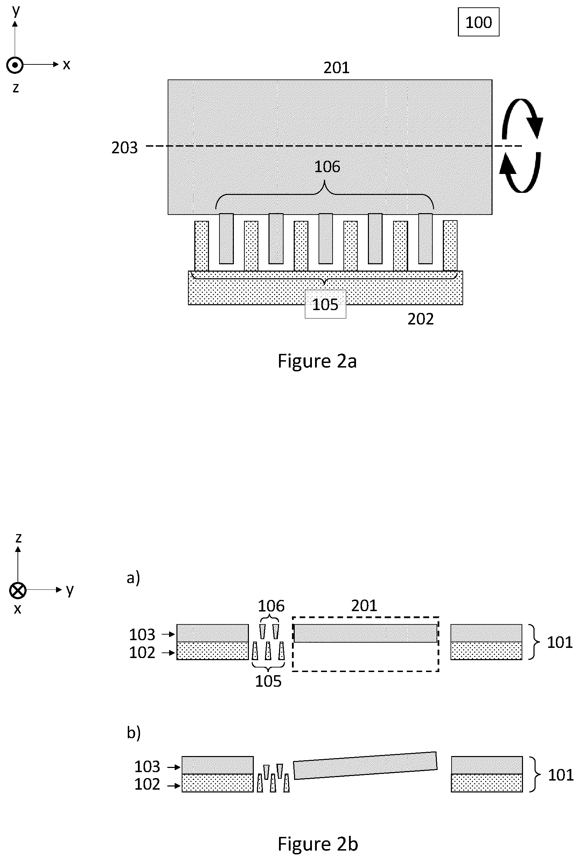

The electrostatic actuator of this disclosure may be attached to a movable element 201. Specifically, the movable element 201 may be attached to the second set of comb fingers 106. Figure 2a illustrates an example of such arrangement. The movable element 201 may be physically connected to at least part of the second set of comb fingers 106. The movable element 201 may comprise structures in the second layer 103, as illustrated in Figure 2b. Alternatively, the movable element 201 may comprise structures in the first 102 and the second 103 layers. Alternatively, the movable element 201 may be outside of the double layer.

The first set of comb fingers 105 may be attached to a first supporting element 202. The first supporting element may be in the first layer 102. The first set of comb fingers 105 may extend away from the first supporting element 202 along the y-direction. The first set of comb fingers may be called a plurality of stator comb fingers. The first supporting element may be called a stator supporting element. The plurality of stator comb fingers and the stator supporting element may form a stator.

The second set of comb fingers 106 may be attached to the movable element 201. Alternatively, the second set of comb fingers 106 may be attached to a second supporting element (not illustrated), which may be a part of the movable element 201. The second set of comb fingers 106 may extend away from the movable element 201 along the y-direction. The actuator may be configured to rotate the movable element 201 around a first rotation axis 203, or to detect rotation about this axis. The first rotation axis 203 may be in the horizontal plane. Alternatively, the actuator may be configured to move the movable element linearly in the z-direction, or to detect such linear movement. The second set of comb fingers 106 may be called a plurality of rotor comb fingers. The plurality of rotor comb fingers and the movable element form a rotor.

Figure 2b illustrates a cross-section of the actuator of Figure 2a described above in a) non-actuated state and b) actuated state. Specifically, it illustrates how the electrostatic actuator moves in response to the applied electric field and rotates the movable element 201 around the first rotation axis 203. The first rotation axis 203 may be parallel to the x-direction.

When an electric field is applied between the first set 105 and the second set 106 of comb fingers, the comb fingers of the second set 106 move with respect to the comb fingers of the first set 105. The movable element 201 may follow the movement of the second set of comb fingers 106 and move out of xy-plane. This movement is out of xy-plane around the first rotation axis 203 and may be called out-of-plane translating movement. In other words, the electrostatic actuator may be configured to oscillate the movable element 201 out of the horizontal plane around the first rotation axis 203. The oscillation may be at slow frequency, which may, for example, be 500 Hz.

The electrostatic actuator of this disclosure may be used for slow axis (quasi-static) excitation to translate the movable element around the first rotation axis as in Figure 2b. In quasi-static mode, the movable element is driven outside of the resonance and may be statically placed to a certain angle in relation to xy-plane. The comb fingers of the first set and the second set are manufactured in different layers and have the gap in between. The advantage of this arrangement is that it allows large tilt angles and displacement of parts remote from the first rotation axis.

Although the comb fingers of the first set and the second set do not physically overlap in the absence of excitation, the electric force between them is nevertheless present due to fringe fields. However, if the gap is too large, an additional excitation may be required (for example, additional capacitive electrodes). The electric force between the comb fingers is further increased by tapering as described above. Furthermore, more effective excitation may be achieved by designing the movable elements to be as loose as possible for reducing the required excitation force.

### Examples of structure with actuator

### Example 1

The micromechanical electrostatic, wherein the micromechanical electrostatic actuator comprises four first sets of comb fingers and four second sets of comb fingers, and wherein one first set of comb fingers and one second set of comb fingers form an actuation element, and wherein the micromechanical electrostatic actuator comprises four actuation elements.

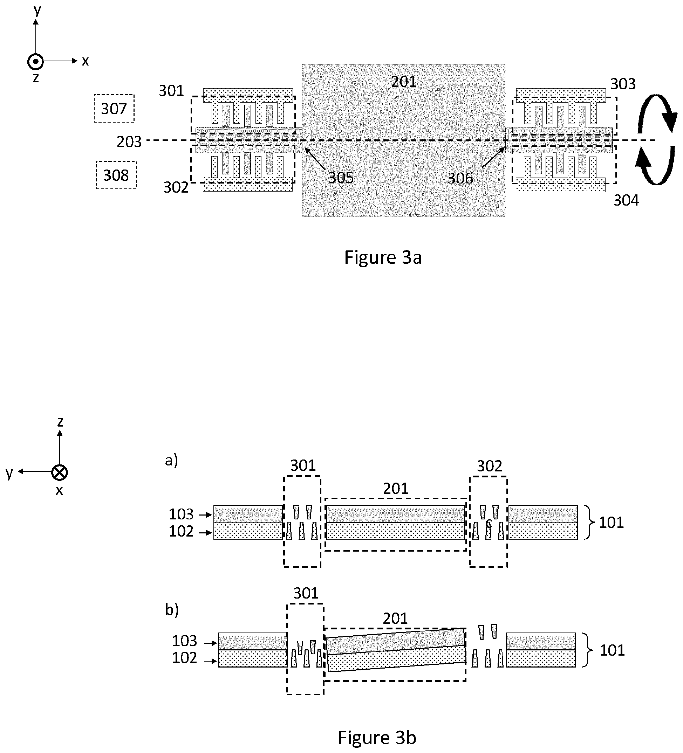

The electrostatic actuator may comprise more than one first set of comb fingers and more than one second set of comb fingers. Figure 3a illustrates an example of electrostatic actuator which comprises four first sets of comb fingers and four second set of comb fingers. Four first sets of comb fingers and four second set of comb fingers may be arranged into four actuator elements 301-304. Specifically, each of four first sets of comb fingers and each of four second sets of comb fingers may form one actuator element out of four actuator elements 301-304.

The movable element 201 may comprise at least two second supporting elements 305-306, which may be attached to the outside of the movable element 201. The second supporting elements may be at least partially attached to the comb fingers of four second sets. The second supporting elements 305-306 may extend away from the movable element 201 along the first rotation axis 203. The second supporting elements may be in the first layer 102. The second supporting elements may be in the second layer 103. Alternatively, the second supporting elements may be in the first layer 102 and in the second layer 103. Having the second supporting elements in the first 102 and the second 103 layers may provide more rigidity to the structure.

Comb fingers of the second sets of four actuator elements 301-304 may be attached to the second supporting elements 305-306. Specifically, comb fingers of the second sets of two actuator elements 301-302 may be attached to the opposite sides of the second supporting element 305, and comb fingers of the second sets of two actuator elements 303-304 may be attached to the opposite sides of the second supporting element 306. The comb fingers of the second sets of actuator elements 301 and 303 may be attached to the second supporting elements 305 and 306 at a first side 307 from the first rotation axis 203. The comb fingers of the second sets of actuator elements 302 and 304 may be attached to the second supporting elements 305 and 306 at a second side 308 from the first rotation axis 203.

Figure 3b illustrates a cross-section of the exemplary structure of Figure 3a in a) non-actuated state and b) actuated state. The movable element 201 may be configured to rotate around the first rotation axis 203 when particular actuation elements (for example 301 and 303) are actuated. For example, when the electric field is simultaneously applied between the comb fingers of a first actuator structure 301 and between the comb fingers of a third actuator structure 303 (not illustrated in Figure 3b), the comb fingers of the second set move with respect to the comb fingers of the first set out xy-plane. Out-of-plane translating comb fingers of the second set generate force in the direction of their displacement and move the movable structure 201 in the same direction around the first rotation axis 203. In other words, the actuator structures may be configured to oscillate the moving structure around the first rotation axis 203. The frequency of oscillation may, for example, be 500 Hz. The actuator structures may be electrically separated and may be independently activated. Tapering of the comb fingers, as shown in Figure 3b and described above, may increase electric force between them and allow lower actuation voltage than would be required with non-tapered comb fingers.

### Example 2

The micromechanical electrostatic actuator, wherein the micromechanical electrostatic actuator comprises eight first sets of comb fingers and eight second sets of comb fingers, and wherein the micromechanical electrostatic actuator comprises eight actuation elements.

The micromechanical electrostatic actuator, wherein the movable element comprises a reflector.

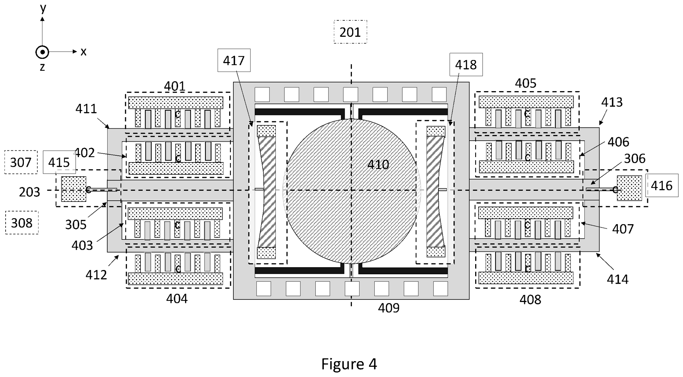

Another example of the electrostatic actuator is illustrated in Figure 4. The electrostatic actuator may comprise eight first sets of comb fingers and eight second sets of comb fingers. Eight first sets of comb fingers and eight second set of comb fingers may be arranged into eight actuator elements 401-408.

In addition, the movable element 201 of Figure 4 may comprise a frame 409 and a reflector 410. The reflector may be suspended inside the frame 409. The reflector 410 may be movable in relation to the frame 409. The frame 409 may be in the second layer 103. Alternatively, the frame 409 may be in the first layer and in the second layer 102. Having the frame in the first and the second layers may provide more rigidity to the frame structure. The reflector 410 may be in the double layer 101. Alternatively, the reflector 410 may be in the first layer 102. Alternatively, the reflector 410 may be in the second layer 103. The reflector 410 may comprise a reflective coating deposited onto one of the layers 102 or 103 (not illustrated in Figure 4). The reflective coating may be one or more metal thin film layers, such as aluminium, silver, gold or copper films. Alternatively, the coating may comprise a stack of one or more dielectric films with different refractive indexes, where the films are arranged so that the stack reflects light. A thickness of the reflective coating may be 100 - 1000 nm. For example, the thickness of the reflective coating may be 500 nm.

The movable element 201 may comprise at least two second supporting elements 305-306, which may be attached to the outside of the frame 409, as described above. The second supporting elements 305-306 may be attached to the frame 409. The movable element 201 may further comprise at least four additional second supporting elements 411-414. Two of the at least four additional second supporting elements (such as, for example 411 and 413) may be on the first side 307 from the first rotation axis 203, and two of the at least four additional second supporting elements (such as, for example 412 and 414) may be on the second side 308 from the first rotation axis 203. Two of the at least four additional second supporting elements (such as, for example 411 and 412) may be attached to one second supporting element 305, and two of the at least four additional second supporting elements (such as, for example 413 and 414) may be attached to the other second supporting element 306. The four additional second supporting elements may be attached to the frame 409.

The additional second supporting elements may be in the first layer 102. The additional second supporting elements may be in the second layer 103.

Alternatively, the additional second supporting elements may be in the first layer 102 and in the second layer 103. Having the additional second supporting elements in the first 102 and the second 103 layers may provide more rigidity to the structure.

The comb fingers of the second sets of eight actuator elements 401-408 may be attached to four additional second supporting structures 411-414. Specifically, two actuator elements 401-402 may be attached to the opposite sides of the additional second supporting structure 411, two actuator elements 403-404 may be attached to the opposite sides of the additional second supporting structure 412, two actuator elements 405-406 may be attached to the opposite sides of the additional second supporting structure 413, and two actuator elements 407-408 may be attached to the opposite sides of the additional second supporting structure 414. The actuator elements 401, 402, 405 and 406 may be at the first side 307 from the first rotation axis 203. The actuator elements 403, 404, 407 and 408 may be the second side 308 from the first rotation axis 203.

Some comb fingers of the first sets of four actuator structures at the first side 307 from the first rotation axis 203 may extend in the direction opposite to y-direction. Some comb fingers of the first sets of four actuator structures at the first side 307 from the first rotation axis 203 may extend in the y-direction. Some comb fingers of the second sets of four actuator structures at the second side 308 from the first rotation axis 203 may extend in the y-direction. Some comb fingers of the second sets of four actuator structures at the second side 308 from the first rotation axis 203 may extend in the direction opposite to y-direction.

The movable element 201 may be configured to rotate around the first rotation axis 203 when particular actuation elements (for example 401-402 and 405-406) are actuated. For example, when the electric field is simultaneously applied between the comb fingers of the actuator structures 401-402 and between the comb fingers of the actuator structures 405-406, the comb fingers of the second sets move with respect to the comb fingers of the first sets out xy-plane. Out-of-plane translating comb fingers of the second set generate force in the direction of their displacement and move the movable structure 201 in the same direction around the first rotation axis 203. In other words, the actuator structures may be configured to oscillate the frame 409 with the reflector 410 around the first rotation axis 203. The frequency of oscillation may, for example, be 500 Hz. The actuator structures may be electrically separated and may be independently activated. Tapering of the comb fingers, as described above, may increase electric force between them and allow lower actuation voltage than would be required with non-tapered comb fingers.

The device of Figure 4 may further comprise at least two outer anchor structures 415-416. Each of the outer anchor structures 415-416 may be attached to each of the second supporting elements. The outer anchor structures 415-416 may comprise a torsion spring and an anchor point each. In addition, the device of Figure 4 may further comprise at least two inner anchor structures 417-418. The inner anchor structures 417-418 may be attached to the opposite sides of the inside of the frame 409. Each of the inner anchor structures 417-418 may comprise a torsion bar, a torsion spring, and two anchor points at the opposite sides of the torsion bar.

The frame 409 may be perforated as in Figure 4. In other words, the frame may have openings to lighten the frame structure while keeping it rigid and increase parasitic resonance frequencies. The openings may be along the entire frame. Alternatively, the openings may be in two opposite sides of the frame as in Figure 4.

The movable element described in Figure 4 may be a MEMS mirror. Alternatively, the movable element may be a MEMS resonator. Alternatively, the movable element may be a MEMS drive force generating actuator. In other words, the electrostatic actuator of this disclosure may be implemented in MEMS mirrors, MEMS resonators or MEMS drive force generating actuator.

### Example of the fabrication method

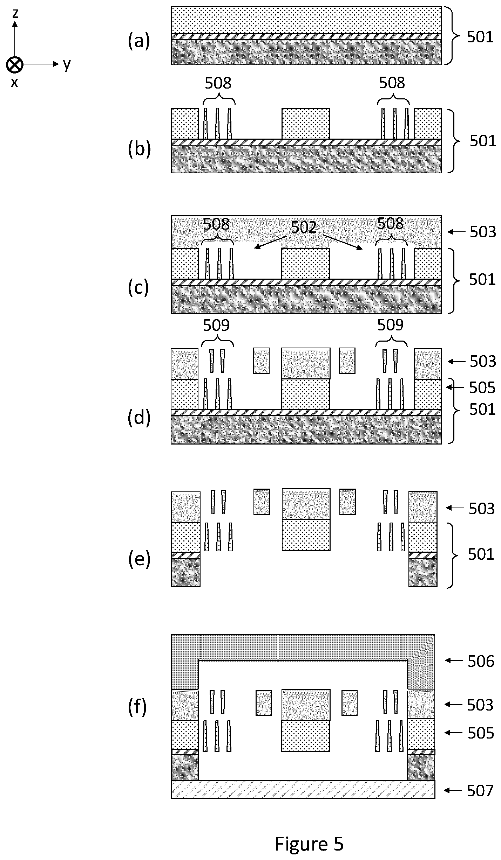

An exemplary manufacturing method of the electrostatic actuator according to any of the embodiments presented above is described with reference to Figure 5. The manufacturing method may include the following steps:
(a) - (b): Taking silicon-on-insulator (SOI) wafer 501 and making deep silicon etching to its device layer. A first set of tapered comb fingers 508 may be formed.
(c) - (d): Making recessing to bottom of a silicon (Si) wafer with LOCal Oxidation of Silicon (LOCOS) to obtain recessed areas 502 with the first set of tapered comb fingers 508, and c) attaching recessed Si wafer 503 to the initial SOI wafer 501, and d) making deep silicon etching to the Si wafer 503 to form second set of tapered comb fingers 509. An obtained structure comprises a recessed first layer 503 and a recessed second layer 505, which may correspond to the layers 102 and 103 defined earlier in this disclosure.
(e): Making deep silicon etching to the backside of SOI wafer 501 and removing the buried oxide of the movable element.
(f): Adding a cap wafer 506 on top of the first layer and a transparent window 507 to the bottom of the second layer.

The material of the cap wafer 506 may be silicon. The material of the transparent window 507 may be glass.

The exemplary manufacturing method above may further comprise patterning of signal routes and contact electrodes onto the first layer and the second layer. Specifically, the electrical contacts may be patterned at the comb fingers of the electrostatic actuators.

## Claims

1. A microelectromechanical electrostatic actuator (100) comprising
- a double layer (101), wherein the double layer defines a horizontal plane and a vertical direction, wherein the vertical direction is perpendicular to the horizontal plane, and wherein the horizontal plane defines an x-direction, and wherein the double layer comprises an actuator region in the horizontal plane, and wherein the double layer comprises a first layer (102) and a second layer (103), and the first and the second layers are one above the other in the vertical direction;
- a first set of comb fingers (105) in the first layer and a second set of comb fingers (106) in the second layer, wherein the first set of comb fingers and the second set of comb fingers are aligned in the actuator region;
- and wherein the x-direction width of the comb fingers of the first set is tapered along the vertical direction
**characterized in that**
- a top surface of the first layer is directly attached to a bottom surface of the second layer.

2. The micromechanical electrostatic actuator according to claim 1, wherein the x-direction width of the comb fingers of the second set (106) is tapered along the vertical direction.

3. The micromechanical electrostatic actuator according to claim 1 or 2, wherein the x-direction width of the comb fingers of the first set (105) and the second set (106) is tapered from 5 um to 2 um.

4. The micromechanical electrostatic actuator according to any of the preceding claims, wherein a movable element (201) is attached to the second set of comb fingers (106) of the micromechanical electrostatic actuator.

5. The micromechanical electrostatic actuator according to claim 4, wherein the movable element (201) is in the double layer.

6. The micromechanical electrostatic actuator according to claim 4 or 5, wherein the movable element (201) is configured to rotate out of the horizontal plane.

7. The micromechanical electrostatic actuator according to any of the preceding claims, wherein material of the double layer (101) is silicon.

8. The micromechanical electrostatic actuator according to any of the preceding claims, wherein a tapering angle is more than 0.1 degrees.

9. The micromechanical electrostatic actuator according to any of the preceding claims, wherein the height of the comb fingers of the first set (105) and the second set (106) in the vertical direction is more than 50 um.

10. A MEMS mirror device comprising a micromechanical electrostatic actuator (100) according to any of claims 1 - 9.

11. A MEMS resonator comprising a micromechanical electrostatic actuator (100) according to any of claims 1 - 9.

12. A MEMS actuator comprising a micromechanical electrostatic actuator (100) according to any of claims 1 - 9.

13. A method of manufacturing a micromechanical electrostatic actuator of claims 1 - 9, comprising steps of:
- providing a silicon-on-insulator wafer (501) and etching its top surface to form a first set of tapered comb fingers (508);
- recessing a bottom surface of a silicon wafer (503) to obtain recessed areas (502) for accommodating the first set of tapered comb fingers;
- attaching the bottom surface of the recessed silicon wafer (503) directly to the top surface of the silicon-on-insulator wafer (501), and etching the recessed silicon wafer (503) to form a second set of tapered comb fingers (509).

## Patentansprüche

1. Mikroelektromechanischer elektrostatischer Aktor (100) umfassend:
- eine Doppelschicht (101), wobei die Doppelschicht eine horizontale Ebene und eine vertikale Richtung definiert, wobei die vertikale Richtung senkrecht zur horizontalen Ebene ist, und wobei die horizontale Ebene eine x-Richtung definiert, und wobei die Doppelschicht eine Aktorregion in der horizontalen Ebene umfasst, und wobei die Doppelschicht eine erste Schicht (102) und eine zweite Schicht (103) umfasst, und die erste und die zweite Schicht sich in der vertikalen Richtung übereinander befinden;
- einen ersten Satz von Kammfingern (105) in der ersten Schicht und einen zweiten Satz von Kammfingern (106) in der zweiten Schicht, wobei der erste Satz von Kammfingern und der zweite Satz von Kammfingern in der Aktorregion aufeinander ausgerichtet sind;
- und wobei sich die Breite der Kammfinger des ersten Satzes in der x-Richtung entlang der vertikalen Richtung verjüngt,
**gekennzeichnet dadurch, dass**
- eine Oberseite der ersten Schicht direkt an einer Unterseite der zweiten Schicht angebracht ist.

2. Mikromechanischer elektrostatischer Aktor nach Anspruch 1, wobei sich die Breite der Kammfinger des zweiten Satzes (106) in der x-Richtung entlang der vertikalen Richtung verjüngt.

3. Mikromechanischer elektrostatischer Aktor nach Anspruch 1 oder 2, wobei sich die Breite der Kammfinger des ersten Satzes (105) und des zweiten Satzes (106) in x-Richtung von 5 µm auf 2 µm verjüngt.

4. Mikromechanischer elektrostatischer Aktor nach einem der vorhergehenden Ansprüche, wobei ein bewegliches Element (201) am zweiten Satz von Kammfingern (106) des mikromechanischen elektrostatischen Aktors angebracht ist.

5. Mikromechanischer elektrostatischer Aktor nach Anspruch 4, wobei sich das bewegliche Element (201) in der Doppelschicht befindet.

6. Mikromechanischer elektrostatischer Aktor nach Anspruch 4 oder 5, wobei das bewegliche Element (201) dazu ausgelegt ist, sich aus der horizontalen Ebene herauszudrehen.

7. Mikromechanischer elektrostatischer Aktor nach einem der vorhergehenden Ansprüche, wobei das Material der Doppelschicht (101) Silicium ist.

8. Mikromechanischer elektrostatischer Aktor nach einem der vorhergehenden Ansprüche, wobei ein Verjüngungswinkel mehr als 0,1 Grad beträgt.

9. Mikromechanischer elektrostatischer Aktor nach einem der vorhergehenden Ansprüche, wobei die Höhe der Kammfinger des ersten Satzes (105) und des zweiten Satzes (106) in der vertikalen Richtung mehr als 50 µm beträgt.

10. MEMS-Spiegelbauelement, das einen mikromechanischen elektrostatischen Aktor (100) nach einem der Ansprüche 1 bis 9 umfasst.

11. MEMS-Resonator, der einen mikromechanischen elektrostatischen Aktor (100) nach einem der Ansprüche 1 bis 9 umfasst.

12. MEMS-Aktor, der einen mikromechanischen elektrostatischen Aktor (100) nach einem der Ansprüche 1 bis 9 umfasst.

13. Verfahren zur Herstellung eines mikromechanischen elektrostatischen Aktors der Ansprüche 1 bis 9, umfassend die Schritte:
- Bereitstellen eines Silicon-on-Insulator-Wafers (501) und Ätzen seiner Oberseite, um einen ersten Satz sich verjüngender Kammfinger (508) auszubilden;
- Eintiefen einer Unterseite eines Siliciumwafers (503), um eingetiefte Bereiche (502) zur Aufnahme des ersten Satzes sich verjüngender Kammfinger zu erhalten;
- direktes Anbringen der Unterseite des eingetieften Siliciumwafers (503) an der Oberseite des Silicon-on-Insulator-Wafers (501), und Ätzen des eingetieften Siliciumwafers (503), um einen zweiten Satze sich verjüngender Kammfinger (509) auszubilden.

## Revendications

1. Actionneur électrostatique microélectromécanique (100) comprenant :
- une double couche (101), la double couche définissant un plan horizontal et une direction verticale, la direction verticale étant perpendiculaire au plan horizontal, et le plan horizontal définissant une direction x, et la double couche comprenant une zone d'actionneur dans le plan horizontal, et la double couche comprenant une première couche (102) et une deuxième couche (103), et les première et deuxième couches étant superposées dans la direction verticale;
- un premier ensemble de dents de peigne (105) dans la première couche et un deuxième ensemble de dents de peigne (106) dans la deuxième couche, le premier ensemble de dents de peigne et le deuxième ensemble de dents de peigne étant alignés dans la zone d'actionneur;
- et dans lequel la largeur dans la direction x des dents de peigne du premier ensemble est rétrécie le long de la direction verticale,
**caractérisé en ce que**
- une surface supérieure de la première couche est directement fixée à une surface inférieure de la deuxième couche.

2. Actionneur électrostatique micromécanique selon la revendication 1, dans lequel la largeur dans la direction x des dents de peigne du deuxième ensemble (106) est rétrécie le long de la direction verticale.

3. Actionneur électrostatique micromécanique selon la revendication 1 ou 2, dans lequel la largeur dans la direction x des dents de peigne du premier ensemble (105) et du deuxième ensemble (106) est rétrécie de 5 µm à 2 µm.

4. Actionneur électrostatique micromécanique selon l'une des revendications précédentes, dans lequel un élément mobile (201) est fixé au deuxième ensemble de dents de peigne (106) de l'actionneur électrostatique micromécanique.

5. Actionneur électrostatique micromécanique selon la revendication 4, dans lequel l'élément mobile (201) est situé dans la double couche.

6. Actionneur électrostatique micromécanique selon la revendication 4 ou 5, dans lequel l'élément mobile (201) est configuré pour une rotation hors du plan horizontal.

7. Actionneur électrostatique micromécanique selon l'une des revendications précédentes, dans lequel le matériau de la double couche (101) est le silicium.

8. Actionneur électrostatique micromécanique selon l'une des revendications précédentes, dans lequel un angle de rétrécissement est supérieur à 0,1 degré.

9. Actionneur électrostatique micromécanique selon l'une des revendications précédentes, dans lequel la hauteur des dents de peigne du premier ensemble (105) et du deuxième ensemble (106) dans la direction verticale est supérieure à 50 µm.

10. Dispositif de miroir MEMS comprenant un actionneur électrostatique micromécanique (100) selon l'une des revendications 1 à 9.

11. Résonateur MEMS comprenant un actionneur électrostatique micromécanique (100) selon l'une des revendications 1 à 9.

12. Actionneur MEMS comprenant un actionneur électrostatique micromécanique (100) selon l'une des revendications 1 à 9.

13. Procédé de fabrication d'un actionneur électrostatique micromécanique selon l'une des revendications 1 à 9, comprenant les étapes consistant à :
- fournir une tranche de silicium sur isolant (501) et graver sa surface supérieure afin de former un premier ensemble de doigts de peigne rétrécis (508);
- évider une surface inférieure d'une tranche de silicium (503) afin d'obtenir des zones évidées (502) pour loger le premier ensemble de doigts de peigne rétrécis;
- fixer la surface inférieure de la tranche de silicium évidée (503) directement à la surface supérieure de la tranche de silicium sur isolant (501), et graver la tranche de silicium évidée (503) afin de former un deuxième ensemble de doigts de peigne rétrécis (509).
